Europäisches Patentamt

European Patent Office

Office européen des brevets

(11) Publication number: **0 307 597**
**A1**

## (12) EUROPEAN PATENT APPLICATION

(21) Application number: **88112310.3**

(22) Date of filing: **29.07.88**

(51) Int. Cl.4: **H05K 1/00 , G06F 13/40**

(30) Priority: **15.09.87 IT 2233087 U**

(43) Date of publication of application:
**22.03.89 Bulletin 89/12**

(84) Designated Contracting States:
**AT BE CH DE ES FR GB GR LI LU NL SE**

(71) Applicant: **MICROSET S.R.L.**
**Viale Italia, 4**
**I-25122 Brescia(IT)**

(72) Inventor: **Bellini, Mario**
**Via Stretta 196**
**I-25060 Mompiano Brescia(IT)**

(74) Representative: **Münzhuber, Robert,**
**Dipl.-Phys.**
**Patentanwalt Rumfordstrasse 10**
**D-8000 München 5(DE)**

(54) **Printed circuit mother board for busses of microprocessors.**

(57) In the printed circuit mother board (1) for busses of microprocessors each track (4) of the printed circuit is separated from the adjacent one by a ground track (5) permitting the signals flowing in the printed circuit tracks (4) to be insulated from each other and this both on the component side (2) and the welding side (3) of the mother board (1). The ground tracks (5) are connected to each other by ground bridges (6).

Fig 1

EP 0 307 597 A1

## PRINTED CIRCUIT MOTHER BOARD FOR BUSSES OF MICROPROCESSORS

The present invention generally relates to the field of printed circuit boards and, more particularly, to a mother board provided with printed circuit, for busses of microprocessors of improved type as far as the electrical ground is concerned.

The conventional printed circuit cards or boards for use in microprocessors are generally formed of a plate of insulating material on both surfaces of which the electrically conductive metal tracks forming the circuits intended to connect the several board components and to connect the board to the microprocessor are printed.

Such boards are provided with an electrical ground layer generally located intermediate the two surfaces on which the electrically conductive metal tracks are printed.

However, since there is no electrical ground among the several tracks of the printed circuit, the mother boards will exhibit a treshold to the clock frequency to which they can operate and beyond this treshold the signals flowing in these tracks of the printed circuit can interfere therebetween.

The object of the present invention is to provide a printed circuit mother board improved as far as the electrical ground is concerned so as to permit this mother board to be able to operate at high clock frequency without any interference among the signals flowing in adjacent tracks of the printed circuit.

According to the invention, the printed circuit mother board for busses of microprocessors is characterized in that each track of the printed circuit is separated from the adjacent one by a ground track which permits the signals flowing in said printed circuit tracks to be insulated from each other and this both on the component side and the welding side of the mother board.

Furthermore, the ground tracks provided on one surface of the printed circuit mother board are electrically connected to the ground tracks provided on the opposite surface of the printed circuit mother board.

Preferably, the ground tracks on both the surfaces of the mother board are connected to each other by ground bridges.

Suitably, the ground tracks lie all on the same plane.

The present invention will be now described in more detail in connection to the accompanying drawings, wherein:

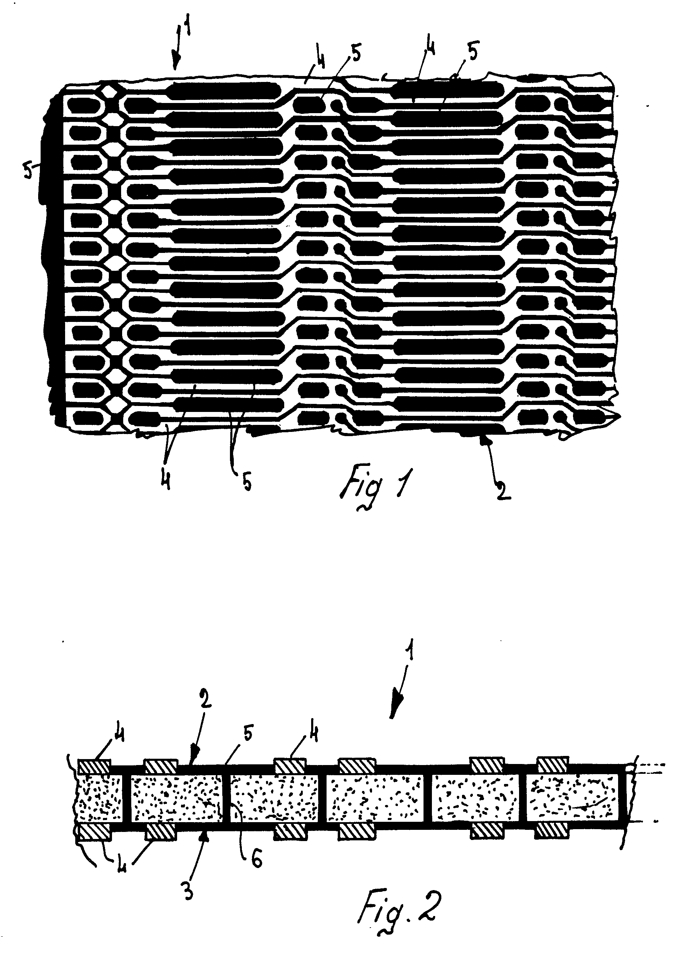

Fig. 1 shows in a plan partial view a section of a printed circuit mother board according to the present invention;

Fig. 2 shows, in a cross sectional view, a section of the mother board of Fig. 1, in an enlarged scale; and

Fig. 3 diagrammatically shows a layout of a 64 pin connector which an be employed of the mother board of Fig. 1.

As can be seen from the drawings, numeral 1 designates the printed circuit mother board according to the present invention, which is suitable for busses of microprocessors. On the surface 2 thereof bearing the components of the circuit and on the surface 3 bearing the weldings, the metal circuit tracks 4 are printed. Between each of the printed circuit tracks 4 and the adjacent one a ground track 5 is provided.

The ground tracks applied on both the surfaces 2 and 3 of the mother board 1 are electrically connected to each other by means of connecting bridges 6, so that all the ground tracks 5 are practically in contact to each other.

By means of this arrangement the mother board can operate with high clock frequency without causing any interference among the signals flowing in the several tracks, thereby making the mother board very effective. However, in order to be able to obtain the configuration of a mother board of this type a lower number of possibility given by the microprocessor has been used, thereby limiting the conventional connector to the external bus to 64 pins only (32 for each surface), but obtaining as a reward a high noise-immunity with a two face printed circuit instead of a multilayer printed circuit.

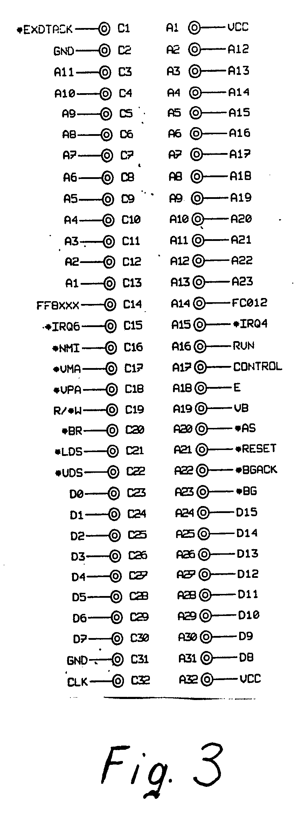

A layout of the arrangement of pins of this connector to the external bus is shown in Fig. 3. A further adavantage of this arrangement is that the more critical clock and external data acknowledge signals (CLK and EXDTACK signals) are further protected because the adjacent pins C32 and C1 respectively are also in ground connection.

Of course, the width and the thickness of the ground tracks are not critical for the present invention.

The ground tracks can be applied by means of any known method and means.

Therefore, it results that the mother board according to the present invention permitting to operate with high clock frequency provides such performances that the mother boards with printed circuits on both the surfaces at present available on the market cannot provide.

## Claims

1) Printed circuit mother board (1) for busses of microprocessors, characterized in that each track (4) of the printed circuit is separated from the adjacent one by a ground track (5), which permits the signals flowing in said printed circuit tracks (4) to be insulated from each other and this both on the component side (2) and the welding side (3) of the mother board (1).

2) Mother board according to claim 1, characterized in that the ground tracks (5) provided on one surface (2) of the printed circuit mother board (1) are electrically connected to the ground tracks (5) provided on the opposite surface (3) of the printed circuit mother board (1).

3) Mother board according to claim 2, characterized in that the connection between the ground tracks (5) on the surfaces (2,3) of the mother board (1) are formed of ground bridges (6) extending through the mother board thickness.

4) Mother board according to claim 1, characterized in that all the ground tracks (5) lie on the same plane.

Fig 1

Fig. 2

| | | | |
|---|---|---|---|
| *EXDTACK —⊚ C1 | A1 ⊚— VCC |
| GND —⊚ C2 | A2 ⊚—A12 |
| A11 —⊚ C3 | A3 ⊚—A13 |
| A10 —⊚ C4 | A4 ⊚—A14 |
| A9 —⊚ C5 | A5 ⊚—A15 |
| A8 —⊚ C6 | A6 ⊚—A16 |
| A7 —⊚ C7 | A7 ⊚—A17 |
| A6 —⊚ C8 | A8 ⊚—A18 |
| A5 —⊚ C9 | A9 ⊚—A19 |
| A4 —⊚ C10 | A10 ⊚—A20 |
| A3 —⊚ C11 | A11 ⊚—A21 |
| A2 —⊚ C12 | A12 ⊚—A22 |
| A1 —⊚ C13 | A13 ⊚—A23 |
| FFBXXX —⊚ C14 | A14 ⊚—FC012 |
| *IRQ6 —⊚ C15 | A15 ⊚—*IRQ4 |
| *NMI —⊚ C16 | A16 ⊚—RUN |
| *VMA —⊚ C17 | A17 ⊚—CONTROL |
| *VPA —⊚ C18 | A18 ⊚—E |
| R/*W —⊚ C19 | A19 ⊚—VB |
| *BR —⊚ C20 | A20 ⊚—*AS |
| *LDS —⊚ C21 | A21 ⊚—*RESET |
| *UDS —⊚ C22 | A22 ⊚—*BGACK |
| D0 —⊚ C23 | A23 ⊚—*BG |
| D1 —⊚ C24 | A24 ⊚—D15 |
| D2 —⊚ C25 | A25 ⊚—D14 |
| D3 —⊚ C26 | A26 ⊚—D13 |
| D4 —⊚ C27 | A27 ⊚—D12 |
| D5 —⊚ C28 | A28 ⊚—D11 |
| D6 —⊚ C29 | A29 ⊚—D10 |
| D7 —⊚ C30 | A30 ⊚—D9 |
| GND —⊚ C31 | A31 ⊚—D8 |
| CLK —⊚ C32 | A32 ⊚—VCC |

# Fig. 3

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| X | US-A-4 130 723 (A.J. WAKELINGS) * Figures 1,2; column 1, lines 14-21,26-49; column 2, lines 9-11,41-44; column 2, line 50 - column 3, line 10; column 3, lines 26-40; claim 1 * | 1-4 | H 05 K 1/00 G 06 F 13/40 |
| | | | TECHNICAL FIELDS SEARCHED (Int. Cl.4) |
| | | | H 05 K |

The present search report has been drawn up for all claims

| Place of search | Date of completion of the search | Examiner |
|---|---|---|
| THE HAGUE | 06-12-1988 | MOMENE Y ARROYO M.E. |

EPO FORM 1503 03.82 (P0401)